# FASCICULE DE BREVET EUROPEEN

(11) **EP 4 435 452 B1**
(45) Date de publication et mention de la délivrance du brevet: **04.11.2026**
(21) Numéro de dépôt: 23162815.7
(22) Date de dépôt: 20.03.2023
(51) Int. Cl.: G01R 31/3835

(54) **PROCEDE D'ESTIMATION DE L'ÉTAT DE CHARGE D'UNE BATTERIE D'UN SYSTÈME À FAIBLE CONSOMMATION, ET SYSTÉME POUR LA MISE EN OEUVRE DU PROCÉDÉ D'ESTIMATION**
VERFAHREN ZUR SCHÄTZUNG DES LADEZUSTANDES EINER BATTERIE EINES SYSTEMS MIT GERINGEM STROMVERBRAUCH UND SYSTEM ZUR DURCHFÜHRUNG DES VERFAHRENS
METHOD FOR ESTIMATING THE STATE OF CHARGE OF A BATTERY OF A LOW-CONSUMPTION SYSTEM, AND SYSTEM FOR IMPLEMENTING THE ESTIMATION METHOD

(43) Date de publication de la demande: 25.09.2024
(73) Titulaire: ETA SA Manufacture Horlogère Suisse, 2540 Grenchen (CH)
(72) Inventeur: NOIRJEAN, José, 2718 Fornet-Dessus (CH)
(74) Mandataire: ICB SA

(56) Documents cités:
- WO-A1-2019/117198
- WO-A1-2021/010622
- US-A1- 2014 172 333
- US-A1- 2017 108 906

## Description

### DOMAINE TECHNIQUE

L'invention se rapporte à un procédé d'estimation de l'état de charge ou de décharge d'une batterie dans un système à faible consommation. Le système à faible consommation peut comprendre un objet portable tel qu'une montre ou une pièce d'horlogerie électronique ou électromécanique, qui peut être alimentée par une batterie ou une pile, telle qu'une pile au lithium.

L'invention se rapporte également à un système pour la mise en œuvre du procédé d'estimation de l'état de charge ou de décharge d'une batterie.

### ARRIERE-PLAN TECHNOLOGIQUE

Il est connu de l'état la technique d'effectuer un contrôle de l'état de charge d'une batterie, comme par exemple pour des applications de véhicules automobiles, en tenant compte également de la température ou d'autres paramètres. Dans l'industrie automobile, il est facile de développer une application d'estimation de l'état de charge des batteries, car les capacités de ces batteries sont élevées et la consommation propre du système d'estimation de l'état de charge SOC est négligeable.

Dans des applications horlogères, l'approximation de l'état de charge d'une montre connectée est réalisée au moyen d'une table de correspondance de la tension de batterie à l'état de charge de 100 points multipliés par trois différentes températures. Les limitations de cette solution sont que l'empreinte mémoire est de grande valeur dans une mémoire de type ROM, de plus la précision de la méthode est médiocre en température et en précision absolue. Il n'y a également pas de compensation pour des phénomènes électrochimiques de la batterie qui sont le temps de relaxation entre la charge et la décharge. La phase de recharge est estimée par un compteur. Beaucoup de codes périphériques doivent être écrits pour gérer les effets de relaxation et d'hystérèse de la batterie dus aux cycles de charge et de décharge.

Il est à noter que la solution la plus adaptée pour effectuer une estimation de l'état de charge, jusqu'à présent, de la batterie réside dans le fait d'utiliser un compteur de Coulomb, qui est un circuit comptabilisant l'énergie prélevée ou récoltée dans la batterie. Cependant, pour la conception de montre ultra basse consommation, cette circuiterie électronique est très onéreuse au niveau énergétique et incompatible avec un système à ultra basse consommation.

L'alimentation par batterie dans des applications horlogères doit se limiter à la tension maximum de la batterie (tension de terminaison) en étant pleinement chargée et ne peut pas descendre en dessous d'une valeur de tension minimum de la batterie (cut-off voltage ou tension de coupure) de manière à ne pas endommager la batterie à disposition pour alimenter le circuit électronique de la montre ou de la pièce d'horlogerie. Il peut encore être imaginé d'utiliser une charge galvanique ou par induction pour assurer une certaine charge de la batterie.

Dans des applications horlogères ou des applications portées par une personne dans une activité sportive par exemple, tel qu'un système GPS, il est utilisé souvent pour l'estimation de l'état de charge de la batterie un compteur de Coulomb comme expliqué ci-dessus. Mais avec ce type de compteur qui a une consommation assez significative, il n'est pas possible de l'utiliser pour des montres ou pièces d'horlogerie à faible consommation ou faible puissance. Tous les composants d'un circuit faible puissance disposé par exemple dans une boîte de montre doivent être à consommation réduite et de ce fait il est contrôlé l'état de charge de la batterie de manière à interrompre l'alimentation du circuit électronique par la batterie lorsque le niveau de tension lue ou mesurée de la batterie s'approche ou est égal à la tension limite basse qui peut être fixée à la tension de coupure de la batterie et générant en pleine charge une tension voisine de la tension de terminal de la batterie.

Le brevet US 10,700,539 B2 décrit un dispositif électronique comprenant un écran et un contrôleur, qui obtient des informations en série chronologiquement concernant une sortie en tension d'une batterie de manière à détecter l'état de charge de la batterie. Il est mentionné dans ce brevet, qu'il est effectué une régression mathématique pour générer une table de correspondance qui est ensuite importée dans une unité à microcontrôleur. Il est donc tenu compte de la table de correspondance une fois qu'elle est dans l'unité à microcontrôleur, ce qui ne permet pas d'effectuer précisément un contrôle de l'état de charge de ladite batterie, ce qui constitue un inconvénient.

Le document US 2014/172333 décrit un procédé permettant d'estimer l'état de charge d'une batterie lithium-ion dans un téléphone mobile, comprenant la conversion de la tension en un état de charge estimé à l'aide d'un premier et d'un deuxième algorithme lorsque l'état de charge se situe respectivement dans une première et une deuxième plage.

### RESUME DE L'INVENTION

La présente invention propose donc un procédé d'estimation de l'état de charge ou de décharge d'une batterie ou d'une pile, qui fournit une information rapidement pour la détermination de l'état de charge ou de décharge par une régression mathématique effectuée directement dans une unité de traitement, qui peut être une unité à microcontrôleur.

Ceci permet de pouvoir adapter rapidement le point de fonctionnement d'un circuit ou module électronique complètement et en palliant les inconvénients cités de l'art antérieur. L'invention permet de faciliter la mesure d'une tension même avec une précision accrue et palliant les inconvénients de l'art antérieur cité ci-dessus.

A cet effet la présente invention concerne un procédé d'estimation de l'état de charge ou de décharge d'une batterie ou d'une pile d'un système de contrôle de charge et de décharge à faible consommation défini dans la revendication indépendante 1.

Des étapes particulières du procédé d'estimation sont définies dans les revendications dépendantes 2 à 5**.**

A cet effet, la présente invention concerne également un système de contrôle de charge ou de décharge pour la mise en œuvre du procédé d'estimation de l'état de charge ou de décharge d'une batterie ou d'une pile à faible consommation défini dans la revendication indépendante 6.

Des formes d'exécution particulières du système de contrôle sont définies dans les revendications dépendantes 7 à 9.

Un avantage du procédé d'estimation de l'état de charge ou de décharge d'une batterie ou d'une pile à faible consommation est le fait que la détermination est effectuée directement dans une unité à microcontrôleur d'un objet portable, qui est de préférence une montre, ce qui permet de donner rapidement l'état de charge ou de décharge d'une batterie ou pile.

Un algorithme de contrôle de l'état de charge ou de décharge d'une batterie ou d'une pile de l'objet portable, notamment d'une montre, est intégré dans l'unité à microcontrôleur de préférence dans le module électronique. Cela permet d'effectuer directement le contrôle de l'état de charge ou de décharge de la batterie pour fournir un résultat rapidement.

Avantageusement, lors de la mise en fonction de l'algorithme dans l'unité à microcontrôleur, il n'est pas utilisé de compteur de Coulomb, ce qui réduit fortement le courant électrique consommé pour déterminer l'état de charge ou de décharge de la batterie ou de la pile. Dans ces conditions, il y a une très basse consommation électrique pour déterminer cet état de charge ou de décharge de la batterie ou de la pile dans la présente invention.

De plus, avec une implémentation de la régression mathématique de l'algorithme directement dans l'unité à microcontrôleur, cela a pour conséquence une empreinte mémoire réduite (memory footprint en terminologie anglaise) pour l'unité à microcontrôleur.

Un autre avantage de la mise en fonction de l'algorithme de l'unité à microcontrôleur de la présente invention est le fait que l'on constate une compensation des artéfacts sur la tension de batterie ou de pile dus à la température et au basculement entre charge et décharge (phénomène d'hystérèse et de relaxation) de la batterie ou de la pile.

### BREVE DESCRIPTION DES FIGURES

Les buts, avantages et caractéristiques du procédé d'estimation de l'état de charge ou de décharge d'une batterie ou d'une pile à faible consommation ou faible puissance et le système pour la mise en œuvre du procédé apparaîtront mieux dans la description suivante de manière non limitative en regard des dessins sur lesquels :
- la figure 1 représente un système de contrôle de l'état de charge ou de décharge d'une batterie ou pile à faible consommation pour la mise en œuvre du procédé d'estimation de l'état de charge ou de décharge d'une batterie ou d'une pile selon la présente invention,
- la figure 2 représente une unité à microcontrôleur d'un module électronique, tel qu'un module de montre, dans lequel un algorithme de contrôle de l'état de charge ou de décharge d'une batterie ou d'une pile est intégré pour le contrôle de l'état de charge ou de décharge d'une batterie ou d'une pile à faible consommation selon l'invention,
- la figure 3 représente des courbes de charge d'une batterie ou d'une pile d'un système de contrôle à faible consommation à différentes températures, et
- la figure 4 représente des courbes de décharge d'une batterie ou d'une pile d'un système de contrôle à faible consommation à différentes températures.

### DESCRIPTION DETAILLEE DE L'INVENTION

Dans la description suivante, il est décrit un procédé d'estimation de l'état de charge ou de décharge d'une batterie ou d'une pile d'un objet portable tel qu'une montre à faible consommation, ainsi que le système pour la mise en œuvre du procédé d'estimation de manière à contrôler précisément l'état de charge ou de décharge d'une batterie ou d'une pile de la montre. De préférence, la montre est équipée d'une source d'énergie sous la forme d'une pile au lithium. Cependant d'autres types de pile peuvent être envisagés.

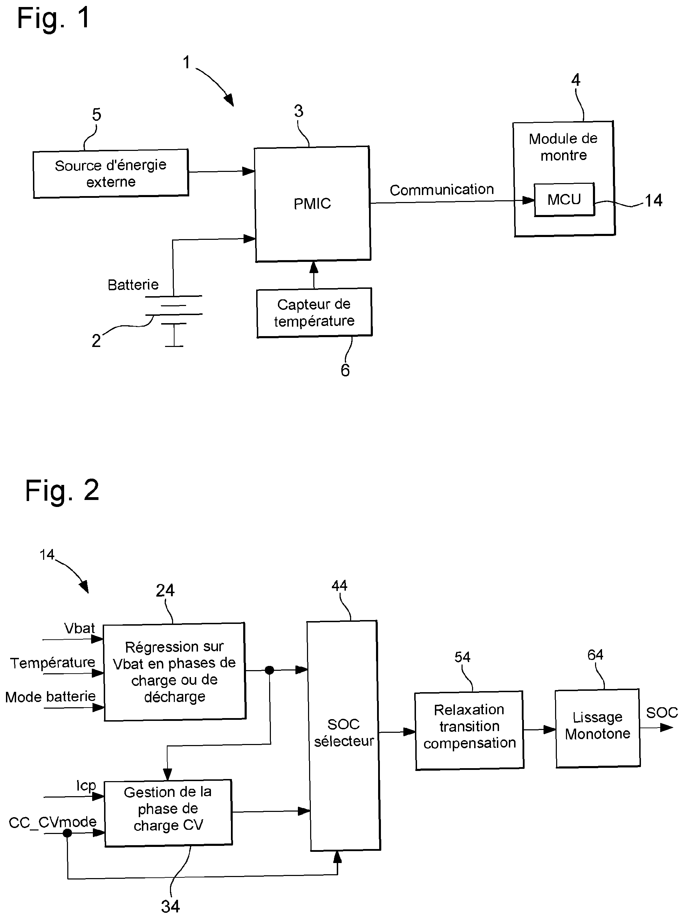

Il est à noter que la présente invention se réfère à un système de contrôle ou d'estimation de l'état de charge, voire de décharge d'une batterie ou d'une pile basse puissance comme représenté à la figure 1. Le système 1 de contrôle ou d'estimation peut être un objet portable, alimenté par une batterie ou pile 2 et muni d'un circuit de gestion de puissance 3 et d'un module 4 à unité de traitement 14. Lors de la mise en œuvre du procédé, le circuit de gestion de puissance 3 communique des données et/ou des paramètres, dont au moins une tension de batterie 2 à l'unité de traitement 14 du module pour la mise en fonction de l'algorithme de contrôle de l'état de charge ou de décharge de la pile 2, qui est mémorisé dans l'unité de traitement.

L'unité de traitement peut être de préférence une unité à microcontrôleur 14 et l'objet portable peut être une montre ou pièce d'horlogerie électronique ou électromécanique à ultra basse consommation électrique comprenant un module horloger 4 à unité à microcontrôleur 14. Cette consommation électrique peut être dans un état de fonctionnement du système de la montre pour le procédé d'estimation de l'état de charge ou de décharge d'une batterie ou d'une pile 2 de montre.

Dans un fonctionnement normal du système 1 d'estimation d'une montre ou d'une pièce d'horlogerie électronique ou électromécanique à faible consommation, il peut y avoir un courant consommé de quelques µA.

Le procédé d'estimation de l'état de charge ou de décharge d'une batterie ou d'une pile 2 d'un système 1 à ultra basse consommation, tel qu'un objet portable, est de préférence une montre ou une pièce d'horlogerie électronique ou électromécanique.

Le système 1 d'estimation d'une charge ou d'une décharge d'une batterie ou d'une pile 2 de la montre ou de la pièce horlogerie comprend au moins la batterie ou la pile 2 reliée à un circuit intégré de gestion de puissance 3 dénommé PMIC. Généralement, ce circuit intégré 3 permet de communiquer directement avec le module horloger 4, qui comprend une unité à microcontrôleur 14 dans laquelle est mémorisée l'algorithme de contrôle de l'état de charge ou de décharge de la pile 2. La communication effectuée du circuit intégré de gestion de puissance 3 comprend des paramètres de contrôle pour la mise en fonction de l'algorithme mémorisé dans l'unité à microcontrôleur 14 du module horloger 4. La mise en fonction de l'algorithme dans l'unité à microcontrôleur 14 sera expliquée ci-dessous en référence à la figure 2 du procédé d'estimation de l'état de charge ou de décharge d'une batterie ou d'une pile. Le but de l'algorithme est de fournir rapidement un état de charge ou de décharge de la batterie ou de la pile 2 à un utilisateur de l'objet portable.

Le procédé d'estimation de l'état de charge ou de décharge d'une batterie ou d'une pile 2 peut être mis en œuvre de manière automatique par périodes définies.

Le système 1 d'estimation de la charge d'une batterie ou d'une pile 2, voire de la décharge de la batterie ou de la pile, peut comprendre encore un capteur de température 6 fournissant une valeur de température au circuit intégré de gestion de puissance 3 de manière à être transmise comme paramètre à l'unité à microcontrôleur 14 du module horloger 4 pour la détermination directe et rapide de l'état de charge ou de décharge de la batterie ou de la pile par l'algorithme de traitement mémorisé dans l'unité à microcontrôleur 14. De plus, une source d'énergie externe 5 peut être branchée au système 1 en liaison directe au circuit intégré de gestion de puissance 3. Cette source d'énergie externe 5 peut être une recharge galvanique ou une recharge à induction.

La figure 2 représente l'unité à microcontrôleur 14 avec tous les éléments de traitement lorsque l'algorithme de contrôle de l'état de charge ou de décharge d'une batterie ou d'une pile est mis en fonction. Le premier bloc fonctionnel 24 prend en compte la tension de batterie Vbat, et le mode de charge ou de décharge. De préférence, ce premier bloc fonctionnel 24 peut prendre encore en considération la température et le mode de fonctionnement de la batterie (charge ou décharge).

L'algorithme met en fonction une régression mathématique à exécuter sur des données réelles de charge ou de décharge de la batterie ou de la pile de préférence à plusieurs niveaux de température, ainsi qu'avec plusieurs courants de charge ou de décharge. Les coefficients de la régression sont ensuite stockés dans une table de correspondance et interpolés par rapport à la température de mesure.

Une sortie du premier bloc fonctionnel 24 est fournie à un second bloc fonctionnel 34 de gestion de phase de charge à tension continue (CV) comme point initial de la régression mathématique. La charge dans le mode à tension continue utilise un pourcentage de courant de charge Icp de la batterie par rapport à son courant de charge maximum et de l'état de la phase ou mode à courant continu (CC) et tension continue (CV). Comme la tension de la batterie n'évolue plus dans le mode à tension continue CV, et qu'il reste de l'énergie à fournir dans la montre par exemple environ 15 % de l'état de charge (SOC), l'état de charge est estimé par régression mathématique avec le courant de charge.

Un troisième bloc fonctionnel 44 défini comme sélecteur de l'état de charge ou de décharge, est relié à la sortie du premier bloc fonctionnel 24 et à la sortie du second bloc fonctionnel 34 en étant commandé par l'état de mode à courant continu et tension continue. Ce bloc 44 se charge de commuter la valeur SOC entre le mode de charge CV et les autres modes avec la régression mathématique du SOC à partir de la tension de batterie.

Le fait de passer d'un courant de charge à un courant de décharge a pour effet sur la tension de batterie de créer des artefacts de surtension ou sous-tension qui ne sont pas du tout en lien avec le SOC de la batterie. Ceci est dû à des phénomènes électrochimiques de la batterie (diffusion des charges). Afin de « retirer » ces artéfacts, la valeur de SOC va être maintenue à l'état précédent avant la transition pendant un temps fixe défini par mesure dans le quatrième bloc fonctionnel 54.

A la transition charge/décharge de la batterie, la valeur de SOC a de légères chutes ou dépassements qui ne reflètent pas l'état du SOC (charge ou décharge). C'est ainsi que la valeur de SOC est filtrée avec une moyenne glissante dans le sixième bloc fonctionnel 64.

L'algorithme proposé offre les avantages suivants :
- L'empreinte mémoire est plus compacte.
- La précision est meilleure en température.
- Les phénomènes de relaxation sont pris en compte.
- La phase à tension continue CV de la charge est prise en compte.
- Le code est simulé ce qui accélère son développement et l'ajustement de ses paramètres.
- Le code est généré automatiquement.

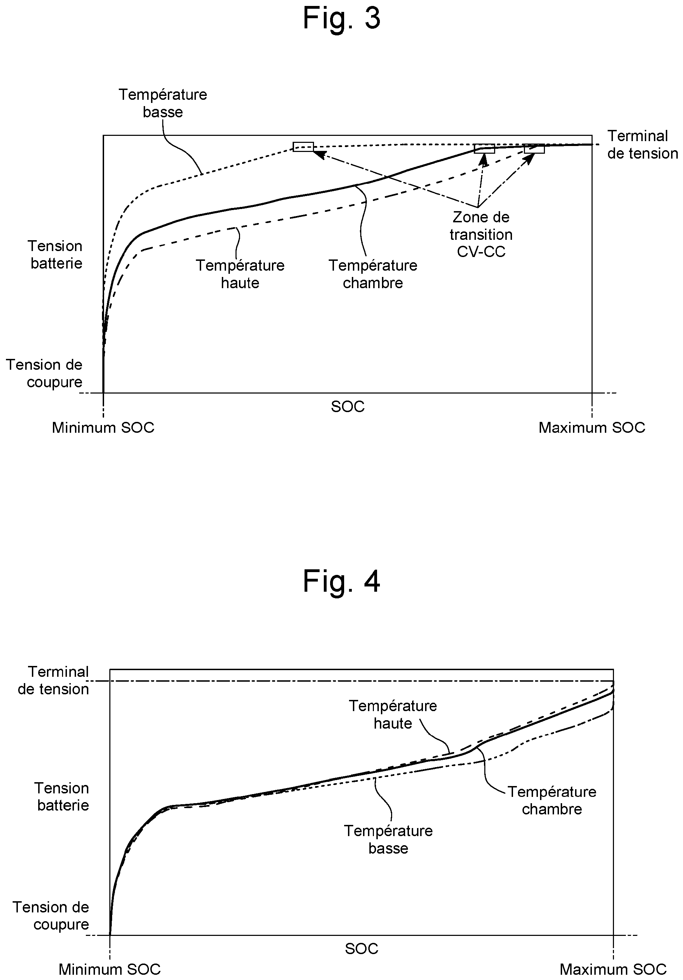

La figure 3 représente des courbes de charge à différentes températures. Dans les courbes de charge, on remarque chaque zone de transition CC-CV, qui sont très différentes et dépendent de la température de la batterie.

La figure 4 représente des courbes de décharge, qui démontrent que l'évolution de la tension à basse température diminue plus vite qu'à plus haute température. Dans la région de basse énergie, la tension de batterie chute très rapidement.

Bien entendu, d'autres possibilités de réalisation du système d'estimation de l'état de charge ou décharge peuvent être envisagées par l'homme du métier sans sortir du cadre de l'invention définie par les revendications.

## Revendications

1. Procédé d'estimation de l'état de charge ou de décharge d'une batterie ou d'une pile (2) d'un système (1) à faible consommation, tel qu'un objet portable qui comprend au moins un circuit de gestion de puissance (3) relié à une batterie ou une pile (2), et une unité de traitement (14) d'un module (4) relié au circuit de gestion de puissance (3),
lors de la mise en œuvre du procédé d'estimation de l'état de charge ou de décharge d'une batterie ou d'une pile (2), au moins une valeur de tension de batterie étant communiquée du circuit de gestion de puissance (3) à l'unité de traitement (14) du module (4) pour la mise en fonction d'un algorithme de contrôle de l'état de charge ou de décharge de la batterie ou de la pile (2), qui est mémorisé dans l'unité de traitement (14) de manière à fournir l'état de charge ou de décharge de la batterie ou de la pile (2),
**caractérisé en ce qu'**un capteur de température du système (1) fournit une valeur de température au circuit de gestion de puissance (3) lors du fonctionnement du système (1) pour une communication en tant que paramètre à l'unité de traitement (14) pour permettre à l'algorithme de contrôle de l'état de charge ou de décharge de la batterie ou de la pile (2), de fournir un état de charge ou de décharge de la batterie ou de la pile (2) dépendant de la température et du mode de fonctionnement de la batterie ou de la pile en charge ou en décharge, **en ce que** l'unité de traitement à microcontrôleur (14) met en fonction l'algorithme de contrôle de l'état de charge ou de décharge de la batterie ou de la pile (2), **en ce que** dans un premier bloc fonctionnel (24), l'algorithme effectue une régression mathématique sur des données réelles de charge ou de décharge de la batterie ou de la pile et pour stocker par la suite des coefficients de la régression dans une table de correspondance, **en ce qu'**une sortie du premier bloc fonctionnel (24) est fournie à un second bloc fonctionnel (34) de gestion de phase de charge à tension continue (CV), **en ce qu'**un troisième bloc fonctionnel (44) définit un état de charge ou de décharge, en étant relié à la sortie du premier bloc fonctionnel (24) et à la sortie du second bloc fonctionnel (34) en étant commandé par un état de mode à courant continu et tension continue, et **en ce que** ce troisième bloc fonctionnel (44) se charge de commuter entre un mode de charge à tension continue (CV) et un autre mode avec la régression mathématique de la tension de batterie.

2. Procédé selon la revendication 1, pour lequel l'unité de traitement (14) du module (4) est une unité à microcontrôleur (14) d'un module électronique (4), **caractérisé en ce que** lors de la mise en œuvre du procédé d'estimation de l'état de charge ou de décharge de la batterie ou de la pile (2), l'unité à microcontrôleur (14) est activée par une communication de données et/ou de paramètres d'un circuit intégré de gestion de puissance (3), et **en ce que** lors de la mise en fonction de l'unité à microcontrôleur (14) l'algorithme de contrôle de l'état de charge ou de décharge de la batterie ou de la pile est mis en fonction pour la détermination de l'état de charge de la batterie ou de la pile (2) ou de décharge de la batterie ou de la pile (2) en fonction d'un mode sélectionné de charge ou d'un mode sélectionné de décharge du circuit intégré de gestion de puissance.

3. Procédé selon l'une des revendications précédentes, **caractérisé en ce que** l'algorithme de contrôle de l'état de charge ou de décharge de la batterie ou de la pile (2) est mis en fonction de manière automatique par périodes définies et contrôlé par l'unité à microcontrôleur (14).

4. Procédé selon la revendication 3, **caractérisé en ce que** la régression mathématique est exécutée sur des données réelles de charge ou de décharge de la batterie ou de la pile à plusieurs niveaux de température, ainsi qu'avec plusieurs courants de charge ou de décharge, et **en ce que** les coefficients de la régression mathématique sont stockés dans la table de correspondance et interpolés par rapport à la température de mesure.

5. Procédé selon la revendication 4, **caractérisé en ce que** le passage d'un courant de charge à un courant de décharge a pour effet sur la tension de la batterie ou de la pile de créer des artefacts de surtension ou sous-tension, **en ce qu'**il est maintenu un état de charge ou décharge précédent avant la transition pendant un temps fixe défini au préalable par une mesure dans un quatrième bloc fonctionnel (54) à la suite du troisième bloc fonctionnel (44), et **en ce que** finalement dans un sixième bloc fonctionnel (64) à la suite du cinquième bloc fonctionnel (54), il est effectué un filtrage par une moyenne glissante.

6. Système (1) configuré pour mettre en œuvre du procédé selon l'une des revendications précédentes, **caractérisé en ce que** le système comprend au moins un circuit de gestion de puissance (3) relié à une batterie ou une pile (2), et une unité de traitement (14) d'un module (4) relié au circuit de gestion de puissance (3).

7. Système (1) selon la revendication 6, **caractérisé en ce que** l'unité de traitement (14) du module (4) est une unité à microcontrôleur (14) d'un module horloger (4).

8. Système (1) selon la revendication 6 ou 7, **caractérisé en ce qu'**il comprend un capteur de température (6) relié au circuit de gestion de puissance (3).

9. Système (1) selon la revendication 6, **caractérisé en ce qu'**il comprend une source d'énergie externe (5), provenant d'une charge galvanique ou d'une charge par induction.

## Patentansprüche

1. Verfahren zur Abschätzung des Lade- oder Entladezustands einer Batterie oder Zelle (2) eines Systems (1) mit geringem Energieverbrauch, wie etwa eines tragbaren Gegenstands, der mindestens einen mit einer Batterie oder Zelle (2) verbundenen Leistungsmanagementschaltkreis (3) und eine Verarbeitungseinheit (14) eines Moduls (4) umfasst, die mit dem Leistungsmanagementschaltkreis (3) verbunden ist,
wobei bei der Durchführung des Verfahrens zur Abschätzung des Lade- oder Entladezustands einer Batterie oder Zelle (2) mindestens ein Batteriespannungswert von dem Leistungsmanagementschaltkreis (3) an die Verarbeitungseinheit (14) des Moduls (4) übermittelt wird, um einen in der Verarbeitungseinheit (14) gespeicherten Algorithmus zur Kontrolle des Lade- oder Entladezustands der Batterie oder Zelle (2) auszuführen, sodass der Lade- oder Entladezustand der Batterie oder Zelle (2) bereitgestellt wird,
**dadurch gekennzeichnet, dass** ein Temperatursensor des Systems (1) während des Betriebs des Systems (1) dem Leistungsmanagementschaltkreis (3) einen Temperaturwert zur Übermittlung als Parameter an die Verarbeitungseinheit (14) liefert, damit der Algorithmus zur Kontrolle des Lade- oder Entladezustands der Batterie oder Zelle (2) einen Lade- oder Entladezustand der Batterie oder Zelle (2) bereitstellen kann, der von der Temperatur und von dem Betriebsmodus der Batterie oder Zelle beim Laden oder Entladen abhängt, dass die Mikrocontroller-Verarbeitungseinheit (14) den Algorithmus zur Kontrolle des Lade- oder Entladezustands der Batterie oder Zelle (2) ausführt, dass der Algorithmus in einem ersten Funktionsblock (24) eine mathematische Regression auf der Grundlage tatsächlicher Lade- oder Entladedaten der Batterie oder Zelle durchführt und anschließend die Regressionskoeffizienten in einer Zuordnungstabelle speichert, dass ein Ausgang des ersten Funktionsblocks (24) einem zweiten Funktionsblock (34) zur Verwaltung einer Ladephase bei konstanter Spannung (CV) zugeführt wird, dass ein dritter Funktionsblock (44) einen Lade- oder Entladezustand definiert, wobei er mit dem Ausgang des ersten Funktionsblocks (24) und dem Ausgang des zweiten Funktionsblocks (34) verbunden ist und durch einen Moduszustand für konstanten Strom und konstante Spannung gesteuert wird, und dass dieser dritte Funktionsblock (44) dazu dient, zwischen einem Lademodus bei konstanter Spannung (CV) und einem anderen Modus mit mathematischer Regression der Batteriespannung umzuschalten.

2. Verfahren nach Anspruch 1, bei dem die Verarbeitungseinheit (14) des Moduls (4) eine Mikrocontroller-Einheit (14) eines elektronischen Moduls (4) ist, **dadurch gekennzeichnet, dass** bei der Durchführung des Verfahrens zur Abschätzung des Lade- oder Entladezustands der Batterie oder Zelle (2) die Mikrocontroller-Einheit (14) durch eine Übermittlung von Daten und/oder Parametern eines integrierten Leistungsmanagementschaltkreises (3) aktiviert wird und dass bei der Aktivierung der Mikrocontroller-Einheit (14) der Algorithmus zur Kontrolle des Lade- oder Entladezustands der Batterie oder Zelle ausgeführt wird, um den Ladezustand der Batterie oder Zelle (2) oder den Entladezustand der Batterie oder Zelle (2) in Abhängigkeit von einem ausgewählten Lademodus oder einem ausgewählten Entlademodus des integrierten Leistungsmanagementschaltkreises (3) zu bestimmen.

3. Verfahren nach einem der vorhergehenden Ansprüche, **dadurch gekennzeichnet, dass** der Algorithmus zur Kontrolle des Lade- oder Entladezustands der Batterie oder Zelle (2) automatisch in festgelegten Zeitabständen ausgeführt und von der Mikrocontroller-Einheit (14) gesteuert wird.

4. Verfahren nach Anspruch 3, **dadurch gekennzeichnet, dass** die mathematische Regression auf der Grundlage tatsächlicher Lade- oder Entladedaten der Batterie oder Zelle bei mehreren Temperaturniveaus sowie bei mehreren Lade- oder Entladeströmen durchgeführt wird und dass die Koeffizienten der mathematischen Regression in der Zuordnungstabelle gespeichert und in Bezug auf die Messtemperatur interpoliert werden.

5. Verfahren nach Anspruch 4, **dadurch gekennzeichnet, dass** der Übergang von einem Ladestrom zu einem Entladestrom bewirkt, dass in der Spannung der Batterie oder Zelle Überspannungs- oder Unterspannungsartefakte entstehen, dass ein vor dem Übergang vorliegender Lade- oder Entladezustand während einer festen Zeit beibehalten wird, die zuvor durch eine Messung in einem vierten Funktionsblock (54) im Anschluss an den dritten Funktionsblock (44) festgelegt wurde, und dass schließlich in einem sechsten Funktionsblock (64) im Anschluss an den fünften Funktionsblock (54) eine Filterung mittels eines gleitenden Mittelwerts durchgeführt wird.

6. System (1), das zur Durchführung des Verfahrens nach einem der vorhergehenden Ansprüche konfiguriert ist, **dadurch gekennzeichnet, dass** das System mindestens einen mit einer Batterie oder Zelle (2) verbundenen Leistungsmanagementschaltkreis (3) und eine Verarbeitungseinheit (14) eines Moduls (4) umfasst, die mit dem Leistungsmanagementschaltkreis (3) verbunden ist.

7. System (1) nach Anspruch 6, **dadurch gekennzeichnet, dass** die Verarbeitungseinheit (14) des Moduls (4) eine Mikrocontroller-Einheit (14) eines Uhrmoduls (4) ist.

8. System (1) nach Anspruch 6 oder 7, **dadurch gekennzeichnet, dass** es einen Temperatursensor (6) umfasst, der mit dem Leistungsmanagementschaltkreis (3) verbunden ist.

9. System (1) nach Anspruch 6, **dadurch gekennzeichnet, dass** es eine externe Energiequelle (5) umfasst, die von einer galvanischen Aufladung oder einer induktiven Aufladung stammt.

## Claims

1. Method for estimating the state of charge or discharge of a battery or a cell (2) of a system (1) having a low power consumption, such as a portable object, which comprises at least one power management circuit (3) connected to a battery or a cell (2), and a processing unit (14) of a module (4) connected to the power management circuit (3),
when the method for estimating the state of charge or discharge of a battery or cell (2) is implemented, at least one battery voltage value being communicated by the power management circuit (3) to the processing unit (14) of the module (4) to run an algorithm for controlling the state of charge or discharge of the battery or cell (2), which algorithm is stored in the processing unit (14) so as to provide the state of charge or discharge of the battery or cell (2),
**characterised in that** a temperature sensor of the system (1) provides a temperature value to the power management circuit (3) during operation of the system (1) for communication as a parameter to the processing unit (14) to allow the algorithm for controlling the state of charge or discharge of the battery or cell (2) to provide a state of charge or discharge of the battery or cell (2) depending on the temperature and operating mode of the battery or cell being charged or discharged, **in that** the microcontroller unit (14) runs the algorithm for controlling the state of charge or discharge of the battery or cell (2), and **in that** in a first functional block (24) the algorithm performs a mathematical regression on actual charge or discharge data of the battery or cell for the subsequent storage of coefficients of the regression in a look-up table, **in that** an output of the first functional block (24) is supplied to a second functional block (34) for managing the phase of DC charging voltage (CV), and **in that** a third functional block (44) defines a state of charge or discharge, by being connected to the output of the first functional block (24) and to the output of the second functional block (34) and by being controlled by a DC current and DC voltage mode state, and **in that** this third functional block (44) is responsible for switching between a DC charging mode (CV) and a another mode with the mathematical regression of the battery voltage.

2. Method according to claim 1, wherein the processing unit (14) of the module (4) is a microcontroller unit (14) of an electronic module (4), **characterised in that** when the method for estimating the state of charge or discharge of the battery or of the cell (2) is implemented, the microcontroller unit (14) is activated by a communication of data and/or parameters from a power management integrated circuit (3), and **in that**, when the microcontroller unit (14) is switched on, the algorithm for controlling the state of charge or discharge of the battery or cell is run in order to determine the state of charge of the battery or cell (2) or the state of discharge of the battery or cell (2) as a function of a selected charge mode or a selected discharge mode of the power management integrated circuit.

3. Method according to one of the preceding claims, **characterised in that** the algorithm for controlling the state of charge or discharge of the battery or cell (2) is run automatically for defined periods and controlled by the microcontroller unit (14).

4. Method according to claim 3, **characterised in that** the mathematical regression is performed on actual charge or discharge data of the battery or cell at several temperature levels, as well as with several charge or discharge currents, and **in that** the coefficients of the mathematical regression are stored in the look-up table and interpolated relative to the measurement temperature.

5. Method according to claim 4, **characterised in that** the transition from a charging current to a discharging current creates overvoltage or undervoltage artefacts on the battery or cell voltage, **in that** a previous state of charge or discharge prior to the transition is maintained for a fastened time previously defined by a measurement in a fourth functional block (54) following the third functional block (44), and **in that** finally, in a sixth functional block (64) following the fifth functional block (54), filtering is performed by a sliding average.

6. System (1) configured for implementing the method according to one of the preceding claims, **characterised in that** the system comprises at least one power management circuit (3) connected to a battery or a cell (2), and a processing unit (14) of a module (4) connected to the power management circuit (3).

7. System (1) according to claim 6, **characterised in that** the processing unit (14) of the module (4) is a microcontroller unit (14) of a horological module (4).

8. System (1) according to claim 6 or 7, **characterised in that** it comprises a temperature sensor (6) connected to the power management circuit (3).

9. System (1) according to claim 6, **characterised in that** it comprises an external energy source (5), originating from a galvanic charger or an inductive charger.
